# DEMANDE DE BREVET EUROPEEN

(11) **EP 1 505 735 A1**
(43) Date de publication de la demande: **09.02.2005**
(21) Numéro de dépôt: 04103807.6
(22) Date de dépôt: 06.08.2004
(51) Int. Cl.: H03K 19/0185, H03K 19/00

(54) **Circuit de transformation de signaux variant entre des tensions différentes**

(30) Priorité: 08.08.2003 FR 0350414
(71) Demandeur: ST MICROELECTRONICS S.A., 92120 Montrouge (FR)
(72) Inventeur: Fournel, Richard, 38660 Lumbin (FR)
(74) Mandataire: de Beaumont, Michel

(57) **Abrégé**

L'invention concerne un circuit d'interface pour transformer un premier signal variant entre une tension basse et une tension haute en un second signal variant entre une tension inférieure et une tension supérieure, la tension inférieure étant plus faible que la tension basse et/ou la tension supérieure étant plus élevée que la tension haute, comprenant: un circuit inverseur (10) recevant le premier signal et étant connecté pour son alimentation entre ladite tension supérieure et ladite tension inférieure, l'une au moins de ces connexions étant effectuée par l'intermédiaire d'au moins une diode (13,14), un élément de conversion alimenté entre lesdites tensions supérieure et inférieure, et recevant la sortie du circuit inverseur et fournissant le second signal, un élément de mémorisation (15,16) adapté à maintenir la sortie du circuit inverseur à ladite tension supérieure ou inférieure quand le premier signal est respectivement égal à la tension basse ou haute.

## Description

La présente invention concerne des circuits pour transformer un premier signal variant entre une tension basse et une tension haute en un second signal variant entre une tension inférieure et une tension supérieure, la tension inférieure étant plus faible que la tension basse et/ou la tension supérieure étant plus élevée que la tension haute.

De tels circuits sont par exemple utilisés comme circuits d'interface entre des circuits fonctionnant avec des tensions d'alimentation différentes. Les circuits peuvent faire partie d'un même circuit intégré alimenté entre une tension supérieure Vdd et une tension inférieure Gnd par exemple 1,2 V et 0 V pour une technologie CMOS dite "0,12 µm". Un des circuits, par exemple une mémoire, est alimenté entre une tension Vmin, par exemple 0,4 V et une tension Vmax, par exemple 0,8 V, et fournit des signaux variant entre les tensions Vmin et Vmax. Les tensions Vmin et Vmax peuvent être produites à partir de la tension Vdd par des convertisseurs de tension continu-continu. Afin de rendre les signaux issus de la mémoire compatibles avec le reste du circuit intégré, un circuit d'interface transforme les signaux variant entre les tensions Vmin et Vmax en des signaux variant entre les tensions Gnd et Vdd.

Un circuit d'interface connu de conception très simple est un inverseur transformant un premier signal variant entre 0,4 V et 0,8 V en un second signal variant entre 0 V et 1,2 V. L'inverseur est par exemple composé d'un transistor PMOS et d'un transistor NMOS dont les sources sont respectivement reliées aux tensions 1,2 V et 0 V. Les grilles des transistors reçoivent le premier signal. Les drains des transistors sont reliés à la sortie de l'inverseur fournissant le second signal. Quelle que soit la valeur de tension du premier signal, les transistors NMOS et PMOS sont toujours conducteurs car leur tension source-grille est supérieure à ladite tension de seuil qui est d'environ 0,4 V pour la technologie "0,12 µm ". Ainsi dans cette application, l'inverseur présente en permanence une consommation. De plus, les niveaux de sortie ne sont pas exactement égaux à 0 V et 1,2 V.

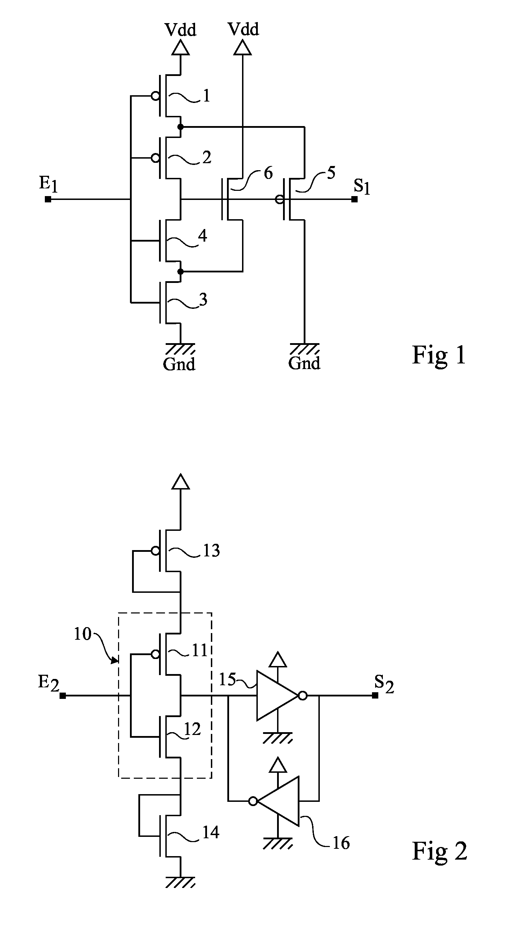

La figure 1 représente un autre circuit d'interface connu sous le nom de "bascule de Schmitt" ("trigger de Schmitt" en anglais). La source d'un transistor PMOS 1 est connectée à la tension Vdd, son drain est relié à la source d'un transistor PMOS 2 dont le drain est relié à la sortie S₁ de la bascule de Schmitt. La source d'un transistor NMOS 3 est connectée à la tension Gnd, son drain est relié à la source d'un transistor NMOS 4 dont le drain est relié à la sortie S₁. Les grilles des transistors 1, 2, 3 et 4 reçoivent sur l'entrée E₁ de la bascule de Schmitt un premier signal variant entre 0,4 V et 0,8 V. La grille d'un transistor PMOS 5 est connectée à la sortie S₁, son drain est relié à la tension Gnd et sa source est reliée au drain du transistor PMOS 1. La grille d'un transistor NMOS 6 est connectée à la sortie S₁, son drain est relié à la tension Vdd et sa source est reliée au drain du transistor NMOS 3.

La bascule de Schmitt fournit sur sa sortie S₁ un second signal qui prend la valeur 0 V quand le premier signal augmente et dépasse un premier seuil de commutation, par exemple 0,7 V et qui prend la valeur 1,2 V quand le premier signal diminue et passe en dessous d'un second seuil de commutation, par exemple 0,5 V. Quand le premier signal vaut 0,4 V, les transistors PMOS 1 et 5 sont conducteurs. Quand le premier signal vaut 0,8 V, les transistors 3 et 6 sont conducteurs. En conséquence, la bascule de Schmitt présente une consommation statique élevée.

Ainsi, un inconvénient commun des deux circuits d'interface décrits précédemment est que leur consommation statique est élevée.

Un objet de la présente invention est de prévoir un circuit d'interface ayant une consommation statique très faible.

Un autre objet de la présente invention est de prévoir un circuit d'interface qui fournit en sortie un signal variant effectivement entre les tensions d'alimentation supérieure Vdd et inférieure Gnd.

Un autre objet de la présente invention est de prévoir un tel circuit d'interface de structure très simple.

Pour atteindre ces objets, la présente invention prévoit un circuit d'interface pour transformer un premier signal variant entre une tension basse et une tension haute en un second signal variant entre une tension inférieure et une tension supérieure, la tension inférieure étant plus faible que la tension basse et/ou la tension supérieure étant plus élevée que la tension haute, ce circuit d'interface comprenant : un circuit inverseur recevant le premier signal et étant connecté pour son alimentation entre ladite tension supérieure et ladite tension inférieure, l'une au moins de ces connexions étant effectuée par l'intermédiaire d'au moins une diode, un élément de conversion et de mémorisation constitué de premier et second inverseurs tête-bêche alimentés entre lesdites tensions supérieure et inférieure, le premier inverseur recevant la sortie du circuit inverseur et fournissant le second signal, et tel que la différence entre la tension basse et la tension inférieure est inférieure ou égale à la somme des tensions de seuil de premières desdites diodes et/ou la différence entre la tension supérieure et la tension haute est inférieure ou égale à la somme des tensions de seuil de secondes desdites diodes.

Selon une variante du circuit d'interface susmentionné, le circuit inverseur est constitué d'un transistor PMOS et d'un transistor NMOS dont les drains sont interconnectés et reliés à la sortie du circuit inverseur, et dont les grilles reçoivent le premier signal.

Selon une variante du circuit d'interface susmentionné, ladite tension basse est égale à ladite tension inférieure et le circuit inverseur est directement connecté à la tension inférieure.

Selon une variante du circuit d'interface susmentionné, ladite tension haute est égale à ladite tension supérieure et le circuit inverseur est directement connecté à la tension supérieure.

Selon une variante du circuit d'interface susmentionné, les diodes sont réalisées avec un transistor NMOS ou PMOS monté en diode.

Selon une variante du circuit d'interface susmentionné, le circuit inverseur le circuit inverseur est une bascule de Schmitt dont la borne d'alimentation supérieure est reliée à ladite tension supérieure et dont la borne d'alimentation inférieure est reliée à ladite tension inférieure.

Selon une variante du circuit d'interface susmentionné, l'élément de conversion et de mémorisation comprend en outre un troisième inverseur dont l'entrée est connectée à la sortie du premier inverseur, la sortie du troisième inverseur fournissant le second signal.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est un schéma, précédemment décrit, d'une bascule de Schmitt ;
la figure 2 est un schéma d'un mode de réalisation d'un circuit d'interface selon la présente invention ;
la figure 3 est un schéma d'un deuxième mode de réalisation d'un circuit d'interface selon la présente invention.

La figure 2 illustre un mode de réalisation de circuit d'interface réalisé pour une technologie "0,12 µm ". Le circuit d'interface reçoit un premier signal sur son entrée E₂ et fournit un second signal sur sa sortie S₂. Le premier signal varie entre 0,4 V et 0,8 V. Le second signal varie entre les tensions d'alimentation Vdd et Gnd respectivement égales à 1,2 V et 0 V.

Un circuit inverseur 10 est composé dans ce mode de réalisation d'un transistor PMOS 11 et d'un transistor NMOS 12. Les grilles des transistors 11 et 12 sont connectées à l'entrée E₂. La source du transistor PMOS 11 est reliée à la tension d'alimentation Vdd par l'intermédiaire d'une diode 13, par exemple un transistor PMOS monté en diode, dont l'anode est reliée à la tension Vdd et la cathode est connectée à la source du transistor PMOS 11. La source du transistor NMOS 12 est reliée à la tension d'alimentation Gnd par l'intermédiaire d'une diode 14, par exemple un transistor NMOS monté en diode, dont la cathode est reliée à la tension Gnd et l'anode est connectée à la source du transistor NMOS 12. La sortie du circuit inverseur 10 est connectée à l'entrée d'un inverseur 15 constituant un élément de conversion. La sortie de l'inverseur 15 est connectée à l'entrée d'un inverseur 16 et à la sortie S₂ du circuit d'interface. La sortie de l'inverseur 16 est connectée à la sortie du circuit inverseur 10. L'ensemble des inverseurs 15 et 16 constituent un élément de mémorisation. Les inverseurs 15 et 16 sont alimentés par les tensions d'alimentation Gnd et Vdd.

Quand le premier signal se stabilise à 0,4 V, par exemple après une commutation de 0,8 V à 0,4 V, le transistor PMOS 11 et la diode 13 deviennent conducteurs. La tension aux bornes de la diode 13 est égale à 0,4 V et la tension source-grille du transistor PMOS 11 est égale à 0,4 V. La taille du transistor PMOS 11 et la taille de la diode 13 sont prévues suffisamment élevées par rapport à la taille du transistor NMOS de l'inverseur 16 de façon que la sortie du circuit inverseur 10 augmente jusqu'à 0,8 V correspondant à la tension Vdd moins la tension de seuil de la diode 13. Une partie du courant traversant le transistor PMOS 11 et la diode 13 passe dans le transistor PMOS 12 et la tension aux bornes de la diode 14 augmente. La tension source-grille du transistor NMOS 12 diminue et devient inférieure à sa tension de seuil. Le transistor NMOS 12 devient alors non conducteur. Le seuil de commutation de l'inverseur 15 est prévu inférieur à 0,8 V de façon que l'inverseur 15 commute ainsi que l'inverseur 16. Le second signal devient nul et le potentiel sur la sortie du circuit inverseur 10 s'élève jusqu'à 1,2 V. Le transistor PMOS 11 est conducteur et le potentiel sur la source du transistor PMOS 11 s'élève jusqu'à 1,2 V. La diode 13 est alors non conductrice.

L'élément de mémorisation constitué des inverseurs 15 et 16 permet de fixer la sortie du circuit inverseur 10 à une tension strictement égale à 1,2 V. En conséquence, la sortie de l'élément de conversion, l'inverseur 15, est strictement égale à 0 V.

Une fois la commutation du circuit d'interface terminée, le transistor NMOS 12, et la diode 14 et le transistor PMOS 13 sont non conducteurs. La tension en sortie du circuit inverseur 10 étant fixe (1,2 V), le transistor PMOS 11 et les inverseurs 15 et 16 sont dans un état stable et leur consommation électrique est quasiment nulle. La consommation statique du circuit d'interface est donc très faible.

Quand le premier signal se stabilise à 0,8 V, par exemple après une commutation de 0,4 V à 0,8 V, le transistor NMOS 12 et la diode 14 deviennent conducteurs. La tension aux bornes de la diode 14 est égale à 0,4 V et la tension source-grille du transistor NMOS 12 est égale à 0,4 V. La taille du transistor NMOS 12 et la taille de la diode 14 sont prévues suffisamment élevées par rapport à la taille du transistor PMOS de l'inverseur 16 de façon que la sortie du circuit inverseur 10 diminue jusqu'à 0,4 V correspondant à la tension de seuil de la diode 14. Une partie du courant traversant le transistor 12 et la diode 14 passe dans le transistor 11 et le potentiel sur la source du transistor PMOS 11 diminue. La tension source-grille du transistor PMOS 11 diminue et devient inférieure à sa tension de seuil. Le transistor PMOS 11 devient alors non conducteur. Le seuil de commutation de l'inverseur 15 est prévu supérieur à 0,4 V de façon que l'inverseur 15 commute ainsi que l'inverseur 16. Le second signal devient égal à 1,2 V et le potentiel sur la sortie du circuit inverseur 10 devient nul. Le transistor NMOS 12 est conducteur et le potentiel sur la source du transistor NMOS 12 diminue et devient nul. La diode 14 est alors non conductrice.

De même que précédemment, une fois la commutation du circuit d'interface terminée, la consommation statique du circuit d'interface est très faible.

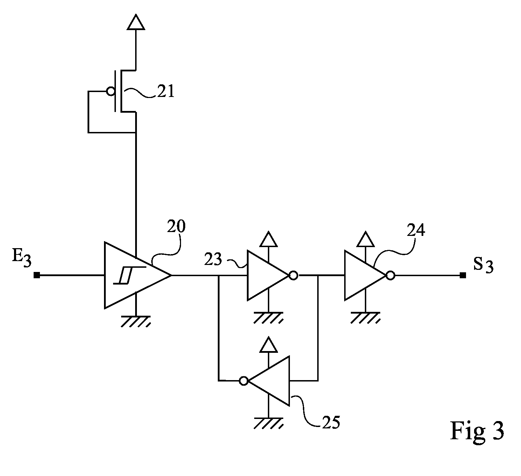

La figure 3 est un schéma d'un autre mode de réalisation de circuit d'interface selon la présente invention. Le circuit d'interface reçoit sur son entrée E₃ un premier signal qui varie entre 0 V et 0,8 V et fournit sur sa sortie S₃, un second signal qui varie entre les tensions d'alimentation égales à 1,2 V et 0 V.

Une bascule de Schmitt 20, identique à celle précédemment décrite en relation à la figure 1, reçoit le premier signal. La borne d'alimentation supérieure de la bascule de Schmitt est reliée à la tension d'alimentation 1,2 V par l'intermédiaire d'une diode 21, par exemple un transistor PMOS monté en diode. L'anode de la diode 21 est connectée à la tension d'alimentation 1,2 V, et sa cathode est connectée à la borne d'alimentation supérieure de la bascule de Schmitt. La borne d'alimentation inférieure de la bascule de Schmitt est directement reliée à la tension d'alimentation 0 V. La sortie de la bascule de Schmitt 20 est connectée à l'entrée d'un inverseur 23. La sortie de l'inverseur 23 est connectée à l'entrée de deux inverseurs 24 et 25. La sortie de l'inverseur 25 est connectée à la sortie de la bascule de Schmitt. La sortie de l'inverseur 24 est connectée à la sortie S₂ du circuit d'interface et fournit le second signal. Les inverseurs 23, 24 et 25 sont alimentés par les tensions d'alimentation 1,2 V et 0 V.

Quand le premier signal passe de 0,8 V à 0 V, la diode 21 devient conductrice et les deux transistors PMOS de la bascule de Schmitt commandés par le premier signal deviennent conducteurs. Les transistors NMOS de la bascule de Schmitt commandés par le premier signal deviennent non conducteurs. Le potentiel sur la sortie de la bascule de Schmitt augmente. L'inverseur 23 commute ainsi que les inverseurs 24 et 25. Le potentiel sur la sortie S₃ du circuit d'interface augmente jusqu'à 1,2 V.

De même, quand le premier signal passe de 0 V à 1,8 V, les deux transistors NMOS de la bascule de Schmitt commandés par le premier signal deviennent conducteurs. Les transistors PMOS de la bascule de Schmitt commandés par le premier signal deviennent non conducteurs. Le potentiel sur la sortie de la bascule de Schmitt diminue. L'inverseur 23 commute ainsi que les inverseurs 24 et 25. Le potentiel sur la sortie S₃ du circuit d'interface devient nul.

Quel que soit le niveau du premier signal, 0,8 V ou 0 V, les transistors de la bascule de Schmitt et le transistor PMOS 21 ne conduisent aucun courant. De même que pour les inverseurs du circuit d'interface de la figure 2, les inverseurs 23, 24 et 25 ont une consommation quasiment nulle. La consommation statique d'un tel circuit d'interface est donc très faible.

Les inverseurs 23 et 25 constituent un élément de mémorisation servant à maintenir la sortie de la bascule de Schmitt à la tension d'alimentation 0 V ou 1,2 V. Les inverseurs 23 et 24 constituent un élément de conversion de la sortie de la bascule de Schmitt en un second signal dont la valeur est précisément égale à 0 V ou 1,2 V. Par rapport au circuit d'interface de la figure 2, l'ajout d'un inverseur avant la sortie du circuit d'interface permet d'avoir un circuit d'interface inverseur.

On notera de plus que quand une des tensions basse ou haute du premier signal est égale respectivement à la tension d'alimentation inférieure ou supérieure, le circuit inverseur recevant le premier signal peut être directement relié à la tension d'alimentation égale à l'une des tensions basse ou haute.

De façon générale, un circuit d'interface selon la présente invention comprend un circuit inverseur classique relié à la tension d'alimentation inférieure Gnd directement ou par l'intermédiaire d'au moins une première diode et relié à la tension supérieure Vdd directement ou par l'intermédiaire d'au moins une seconde diode, ce circuit inverseur étant suivi d'éléments de conversion et de mémorisation. Pour que la consommation statique du circuit d'interface soit la plus faible possible, le nombre de premières diodes est choisi tel que la différence entre le niveau bas du premier signal et la tension d'alimentation inférieure Gnd soit inférieure à la somme des tensions de seuil des premières diodes. De même, le nombre de secondes diodes est choisi tel que la différence entre la tension d'alimentation supérieure Vdd et le niveau haut du premier signal reçu par le circuit d'interface soit inférieure à la somme des tensions de seuil des secondes diodes.

Un avantage du circuit d'interface de la présente invention est que sa consommation statique est très faible.

Un autre avantage d'un tel circuit d'interface est qu'il fournit en sortie un signal variant effectivement entre les tensions d'alimentation supérieure Vdd et inférieure Gnd.

Bien entendu, la présente invention est susceptible de diverses variantes et modifications qui apparaîtront à l'homme de l'art. En particulier, le circuit inverseur peut être n'importe quel circuit adapté à fournir une tension sur sa sortie inverse de celle sur son entrée, une bascule de Schmitt est un exemple. De plus, l'homme de l'art saura définir le nombre de diodes à insérer entre le circuit inverseur et les tensions d'alimentation inférieure Gnd et supérieure Vdd. En outre, l'homme de l'art saura choisir les éléments de conversion et de mémorisation les mieux adaptés. On notera de plus qu'un circuit d'interface selon la présente invention peut transformer un signal variant dans une plage de tensions plus importante que celle initialement prévue, la plage de tensions maximale étant celle définie par les tensions d'alimentation du circuit d'interface.

## Revendications

1. Circuit d'interface pour transformer un premier signal variant entre une tension basse et une tension haute en un second signal variant entre une tension inférieure et une tension supérieure, la tension inférieure étant plus faible que la tension basse et/ou la tension supérieure étant plus élevée que la tension haute, **caractérisé en ce qu'**il comprend :
- un circuit inverseur (10 ; 20) recevant le premier signal et étant connecté pour son alimentation entre ladite tension supérieure et ladite tension inférieure, l'une au moins de ces connexions étant effectuée par l'intermédiaire d'au moins une diode,
- un élément de conversion et de mémorisation constitué de premier et second inverseurs tête-bêche (15, 16 ; 23, 25) alimentés entre lesdites tensions supérieure et inférieure, le premier inverseur recevant la sortie du circuit inverseur et fournissant le second signal,
**caractérisé en ce que** la différence entre la tension basse et la tension inférieure est inférieure ou égale à la somme des tensions de seuil de premières desdites diodes et/ou la différence entre la tension supérieure et la tension haute est inférieure ou égale à la somme des tensions de seuil de secondes desdites diodes.

2. Circuit selon la revendication 1, dans lequel le circuit inverseur est constitué d'un transistor PMOS (11) et d'un transistor NMOS (12) dont les drains sont interconnectés et reliés à la sortie du circuit inverseur, et dont les grilles reçoivent le premier signal.

3. Circuit selon la revendication 1, dans lequel ladite tension basse est égale à ladite tension inférieure et dans lequel le circuit inverseur est directement connecté à la tension inférieure.

4. Circuit selon la revendication 1, dans lequel ladite tension haute est égale à ladite tension supérieure et dans lequel le circuit inverseur est directement connecté à la tension supérieure.

5. Circuit selon la revendication 1, dans lequel les diodes sont réalisées avec un transistor NMOS ou PMOS monté en diode.

6. Circuit selon la revendication 1, dans lequel le circuit inverseur est une bascule de Schmitt (20) dont la borne d'alimentation supérieure est reliée à ladite tension supérieure et dont la borne d'alimentation inférieure est reliée à ladite tension inférieure.

7. Circuit selon la revendication 1, dans lequel l'élément de conversion et de mémorisation comprend en outre un troisième inverseur dont l'entrée est connectée à la sortie du premier inverseur, la sortie du troisième inverseur fournissant le second signal.
